# EUROPEAN PATENT APPLICATION

(11) **EP 4 567 874 A1**
(43) Date of publication of application: **11.06.2025**
(21) Application number: 24212693.6
(22) Date of filing: 13.11.2024
(51) Int. Cl.: H01L 21/768, H01L 23/373, H01L 23/473, H01L 23/48, H05K 7/20

(54) **STRUCTURES AND METHODS TO PROVIDE CONNECTIONS ACROSS CHANNELS**

(30) Priority: 06.12.2023 US 202363606657 P; 29.04.2024 US 202418648836
(71) Applicant: Avago Technologies International Sales Pte. Limited, Singapore 768923 (SG)
(72) Inventor: THEIL, Jeremy, San Jose, 95134 (US)
(74) Representative: Dilg, Haeusler, Schindelmann Patentanwaltsgesellschaft mbH

(57) **Abstract**

Novel tools and techniques are provided for implementing a semiconductor package or a chip package, and more particularly methods, systems, and apparatuses are provided for implementing a semiconductor package or a chip package including a one or more channel vias. In various embodiments, an apparatus includes a first layer (202) comprising a channel and a first via (210) extending through the first layer (202) to a first surface (212) of a first ridge (206) of the first channel (204). The apparatus can further include a second layer (208) coupled to the first layer (202). The second layer (208) can be a first outer layer of the first substrate. The apparatus can also include a first line (214) coupled to the first via (210) and extending along the first ridge (206) of the first channel (204) and embedded in the second layer (208).

## Description

### CROSS-REFERENCE TO RELATED APPLICATION

This application claims priority to U.S. Patent Application Ser. No. 63/606,657 (the " '657 Application"), filed December 6, 2023, by Jeremy Theil, entitled, "Structure for reducing pressure drop requirements in a fluid filled heatsink and enabling electrical connections," the disclosure of which is incorporated herein by reference in its entirety for all purposes.

### COPYRIGHT STATEMENT

A portion of the disclosure of this patent document contains material that is subject to copyright protection. The copyright owner has no objection to the facsimile reproduction by anyone of the patent document or the patent disclosure as it appears in the Patent and Trademark Office patent file or records, but otherwise reserves all copyright rights whatsoever.

### FIELD

The present disclosure relates, in general, to methods, systems, and apparatuses for implementing a semiconductor device comprising a channel with one or more vias.

### BACKGROUND

When working with semiconductor devices in which channels, cavities, or voids exist, there are some constraints on routing traces or vias because there is an engineered channel, cavity, or void within the semiconductor device. Examples of situations where semiconductor devices comprise channels, cavities, or voids include when the semiconductor device comprises one or more coldplates (e.g., fluid coldplates, heatsinks, or the like) across which signals (e.g., electrical signals, or the like) need to be passed or one or more vacuum cavities for sensors and transducers.

Through substrate vias (TSVs) are commonly used to pass the signals through a semiconductor device from or to one or more layers or dies. However, the number, amount, or density of TSVs may be limited in a semiconductor device or one or more areas of the semiconductor device where one or more channels, cavities, or voids are formed.

Hence, there is a need for more robust and scalable solutions for implementing semiconductor packages and chip packages with channels. Thus, methods, systems, and apparatuses are provided for implementing semiconductor packages or chip packages including one or more lines extending across a ridge of a channel.

### BRIEF DESCRIPTION OF THE DRAWINGS

A further understanding of the nature and advantages of particular embodiments may be realized by reference to the remaining portions of the specification and the drawings, in which like reference numerals are used to refer to similar components. In some instances, a sub-label is associated with a reference numeral to denote one of multiple similar components. When reference is made to a reference numeral without specification to an existing sub-label, it is intended to refer to all such multiple similar components.
FIG. 1 is a schematic perspective view of an embodiment of a semiconductor device, in accordance with various embodiments;
FIG. 2 is a top view of the semiconductor device of FIG. 1, in accordance with various embodiments;
FIG. 3 is a top view of an embodiment of the semiconductor device of FIG. 1 with a transparent second substrate, in accordance with various embodiments;
FIG. 4 is a top view of another embodiment of the semiconductor device of FIG. 1 with a transparent second substrate, in accordance with various embodiments;
FIG. 5 is cross-sectional view of the semiconductor device of FIG. 4 taken along line A-A, in accordance with various embodiments;
FIG. 6 is cross-sectional view of the semiconductor device of FIG. 4 taken along line B-B, in accordance with various embodiments;
FIG. 7 is cross-sectional view of the semiconductor device of FIG. 4 taken along line C-C, in accordance with various embodiments;
FIG. 8 is a flow diagram of a method of fabricating a semiconductor device, in accordance with various embodiments.

### DETAILED DESCRIPTION OF EMBODIMENTS

Various embodiments provide tools and techniques for implementing semiconductor packages or chip packages including one or more channels are described herein.

In a first aspect, a semiconductor device can include a first substrate comprising a first layer having a first channel, a first via extending through the first layer to a first surface of a first ridge of the first channel, and a first line coupled to the first via and extending along the first ridge of the first channel and embedded in the second layer. The second layer can be a first outer layer of the first substrate. The first line can be directly or indirectly coupled to the first surface of the first ridge.

In some cases, the first line can be located between the first layer and the second layer. In various instances, the second layer can be a dielectric layer. In some embodiments, the first line can be connected to a bonding pad and the bonding pad can be connected to at least one of a second via, a pad, or a bonding pad located on a second substrate.

In various instances, the semiconductor device can further include a second substrate comprising a third layer comprising a second channel, a second via extending through the third layer to a second surface of a second ridge of the second channel, a fourth layer coupled to the third layer, and a connector connected to the second via and the first line and embedded in the fourth layer. In some cases, the fourth layer can be a second outer layer of the second substrate.

In some embodiments, the connector can be a second line extending across the second ridge of the second channel. In some cases, the first line can be connected to the second line by a bonding pad. In various instances, the connector can be a pad or a bonding pad. In some cases, the second ridge of the second channel can be offset from the first ridge of the first channel. In various embodiments, the second ridge of the second channel can be about perpendicular to the first ridge of the first channel. In some cases, the first via can located over the second channel. In some instances, the second substrate comprises one or more inlet or outlet ports configured to receive a fluid and the fluid can be received in the first channel and the second channel.

In another aspect, a semiconductor device can include a first substrate comprising a first layer comprising a first channel, a first via extending to a first surface of the first layer, the first surface can be a first ridge of the first channel, a second layer coupled to the first layer, the second layer can be a first outer layer of the first substrate, and a first line connected to the first via and extending across the first ridge of the first channel. The semiconductor device can further include a second substrate. The second substrate can include a third layer comprising a second channel, a second via extending to a second surface of the third layer, the second surface can be a surface of a second ridge of the second channel, a fourth layer coupled to the third layer, the fourth layer can be a second outer layer of the second substrate, and a connector coupled to the second via and the first line.

In some cases, the connector can include a second line extending across the second ridge of the second channel.

In various instances, a ratio of a thickness of the second layer to a thickness of the first line can be between about 1:1 to about 30:1.

In another aspect, a method can of manufacturing a semiconductor device can include forming a first substrate comprising forming a first layer, forming a first channel in the first layer, forming a first via in the first layer extending to a first ridge of the first channel, forming a first line extending along the first ridge of the first channel and connected to the first via, and forming a second layer on the first ridge of the first channel and surrounding the first line.

The method can further include forming a second substrate comprising forming a third layer, forming a second channel in the third layer, forming a second via in the third layer extending to a second ridge of the second channel, forming a connector coupled to the third layer and connected to the second via and the first line, and forming a fourth layer on the second ridge of the second channel and surrounding the connector.

In some cases, the connector comprises a second line extending along the second ridge and connected to the first line.

In various embodiments, the second layer can be formed in one or more first selected locations based on one or more first locations where the first line is formed and the fourth layer can be formed in one or more second selected locations based on one or more second locations where the connector is formed.

In the following description, for the purposes of explanation, numerous details are set forth to provide a thorough understanding of the described embodiments. It will be apparent to one skilled in the art, however, that other embodiments may be practiced without some of these details. Several embodiments are described herein, and while various features are ascribed to different embodiments, it should be appreciated that the features described with respect to one embodiment may be incorporated with other embodiments as well. By the same token, however, no single feature or features of any described embodiment should be considered essential to every embodiment of the invention, as other embodiments of the invention may omit such features.

When an element is referred to herein as being "connected," "coupled," or "attached" to another element, it is to be understood that the elements can be directly connected or coupled to the other element, or have intervening elements present between the elements. In contrast, when an element is referred to as being "directly connected," "directly coupled," or "directly attached" to another element, it should be understood that no intervening elements are present in the "direct" connection or coupling between the elements. However, the existence of a direct connection or coupling does not exclude other connections or couplings, in which intervening elements may be present. As used throughout this disclosure, "connect," "connected," etc. can refer to a connection (e.g., electrical connection between one or more elements while "couple," "coupled," etc. can refer to a connection (e.g., mechanical or physical connection, link, or engagement) between one or more elements.

When an element is referred to herein as being "disposed" or "located" in some manner relative to another element (e.g., disposed on, disposed between, disposed under, disposed adjacent to, or disposed in some other relative manner), it is to be understood that the elements can be directly disposed or located relative to the other element (e.g., disposed directly on another element), or have intervening elements present between the elements. In contrast, when an element is referred to as being "disposed directly" or "located directly" relative to another element, it should be understood that no intervening elements are present in the "direct" example. However, the existence of a direct disposition does not exclude other examples in which intervening elements may be present.

Likewise, when an element is referred to herein as being a "layer," it is to be understood that the layer can be a single layer or include multiple layers. For example, a conductive layer may comprise multiple different conductive materials or multiple layers of different conductive materials or combinations of dielectric and conductive materials, or combinations of dielectric or conductive layers, or the like, and a dielectric layer may comprise multiple dielectric materials or multiple layers of dielectric materials or combinations of dielectric and conductive materials, or combinations of dielectric or conductive layers, or the like. When a layer is described as being coupled or connected to another layer, it is to be understood that the coupled or connected layers may include intervening elements present between the coupled or connected layers. In contrast, when a layer is referred to as being "directly" connected or coupled to another layer, it should be understood that no intervening elements are present between the layers. However, the existence of directly coupled or connected layers does not exclude other connections in which intervening elements may be present.

Moreover, the terms left, right, front, back, top, bottom, forward, reverse, clockwise and counterclockwise are used for purposes of explanation only and are not limited to any fixed direction or orientation. Rather, they are used merely to indicate relative locations and/or directions between various parts of an object and/or components. Additionally, terms such as first, second, third, are merely used to distinguish elements or components from each other and are not intended to imply an order, sequence, or amount unless expressly stated otherwise.

Furthermore, the methods and processes described herein may be described in a particular order for ease of description. However, it should be understood that, unless the context dictates otherwise, intervening processes may take place before and/or after any portion of the described process, and further various procedures may be reordered, added, and/or omitted in accordance with various embodiments.

Unless otherwise indicated, all numbers used herein to express quantities, dimensions, and so forth should be understood as being modified in all instances by the term "about." The term "substantially" or "about" used herein refers to variations from the reference value or ratio of ± 20% or less (e.g., ± 20%, ± 15%, ± 10%, ± 5%, etc.), inclusive of the endpoints of the range.

In this application, the use of the singular includes the plural unless specifically stated otherwise, and use of the terms "and" and "or" means "and/or" unless otherwise indicated. Moreover, the use of the terms "including" and "having," as well as other forms, such as "includes," "included," "has," "have," and "had," should be considered non-exclusive. Also, terms such as "element" or "component" encompass both elements and components comprising one unit and elements and components that comprise more than one unit, unless specifically stated otherwise.

As used herein, the phrase "at least one of" preceding a series of items, with the term "and" or "or" to separate any of the items, modifies the list as a whole, rather than each member of the list (i.e., each item). The phrase "at least one of" does not require selection of at least one of each item listed; rather, the phrase allows a meaning that includes at least one of any one of the items, and/or at least one of any combination of the items. By way of example, the phrases "at least one of A, B, and C" or "at least one of A, B, or C" each refer to only A, only B, or only C; and/or any combination of A, B, and C. In instances where it is intended that a selection be of "at least one of each of A, B, and C," or alternatively, "at least one of A, at least one of B, and at least one of C," it is expressly described as such.

In existing semiconductor or chip packages, vias are commonly used to pass signals through a semiconductor device from or to one or more layers, substrates, parts, or components. However, the number, amount, or density of vias may be limited in a semiconductor device or one or more areas of the semiconductor device where one or more channels, cavities, or voids are formed. In a non-limiting example, for certain types of heatsinks it is possible to decrease a pressure drop by inserting a second substrate comprising one or more second channels that run perpendicular to one or more first channels of a first substrate. However, it is difficult to run electrical connections through the first substrate to the second substrate because of the way the second substrate overlaps the second substrate and the need to prevent liquid from interfering with the electrical connections.

The subject technology comprises a semiconductor or chip device (e.g., integrated circuit (IC), chip, or other semiconductor device or module) or interposer (e.g., an interface routing one or more electrical connections between at least two layers or the like) that provides one or more channels (e.g., channels, cavities, voids, openings, etc.). The semiconductor device can include one or more vias (e.g., ridge vias, ridge through substrate vias (TSVs), or the like) extending through one or more layers to a top surface of a ridge (e.g., a ridge, a fin, or the like) of the channel. The vias can be used to route one or more electrical connections through the one or more layers and can be used to ensure electrical contact across an interface (e.g., an interface where two layers couple together, an interface where a die is coupled to a substrate, an interface where two substrates are coupled together, an interface where a die is coupled to a coldplate (e.g., one or more layers comprising channels configured to a contain fluid), or any other interface where two parts of a semiconductor device are coupled together, or the like). However, only providing ridge vias extending through one or more layers to the top surface of the ridge of the channel, cavity, or void can limit the density or number of vias that can be formed within the semiconductor device.

Thus, the subject technology can further provide a first substrate comprising one or more vias extending to a top surface of a first ridge of a first channel and one or more lines extending along the first ridge of the first channel configured to couple to one or more other connectors located on a second substrate. In various cases, the one or more vias can be located over (e.g., above, below, etc.) a second channel of the second substrate. Thus, by routing one or more lines along the first ridge of the first channel, the one or more vias can be coupled to one or more connectors located at a second ridge of the second substrate. In this way, electrical pathways can be formed through portions of the first and second substrate where ridges of the first substrate and the second substrate do not overlap. Additionally, by providing a zero-clearance bonding surface between the first substrate and the second substrate, the zero-clearance bonding surface can insulate the one or more lines thereby preventing fluid from interfering with the one or more vias, one or more lines, one or more connectors or the like.

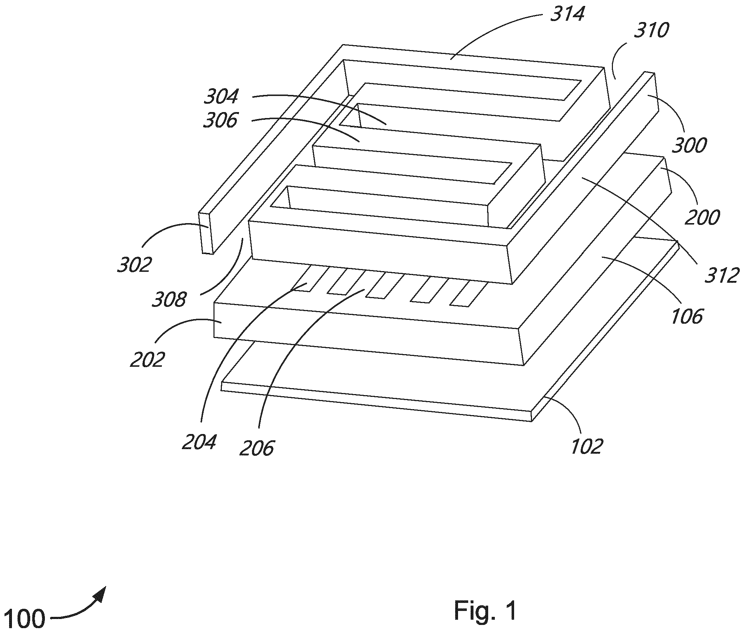

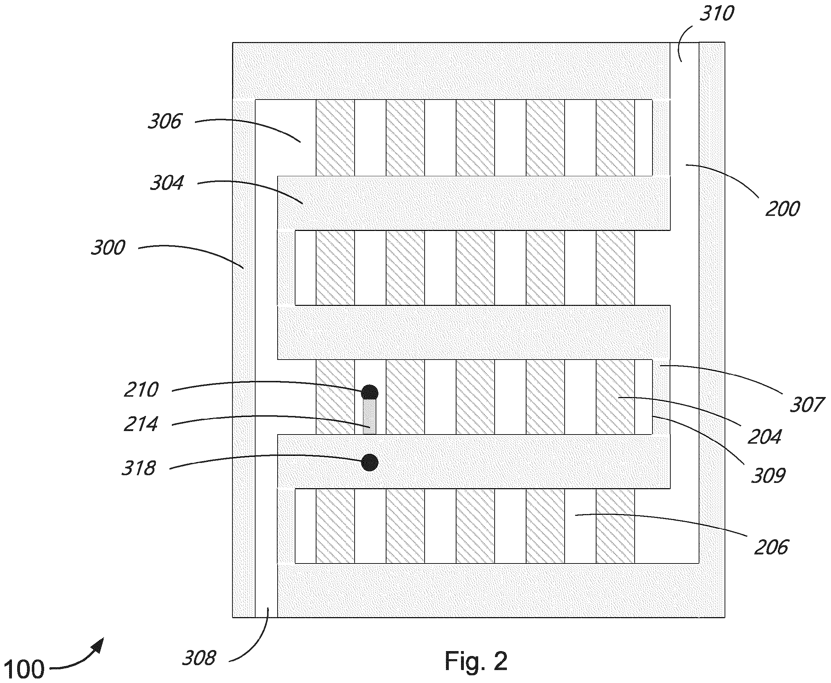

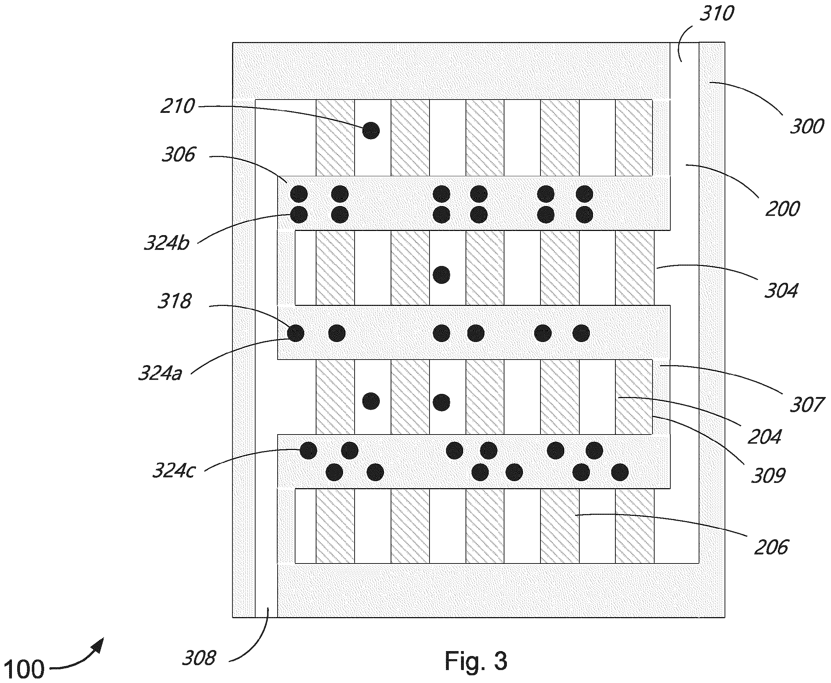

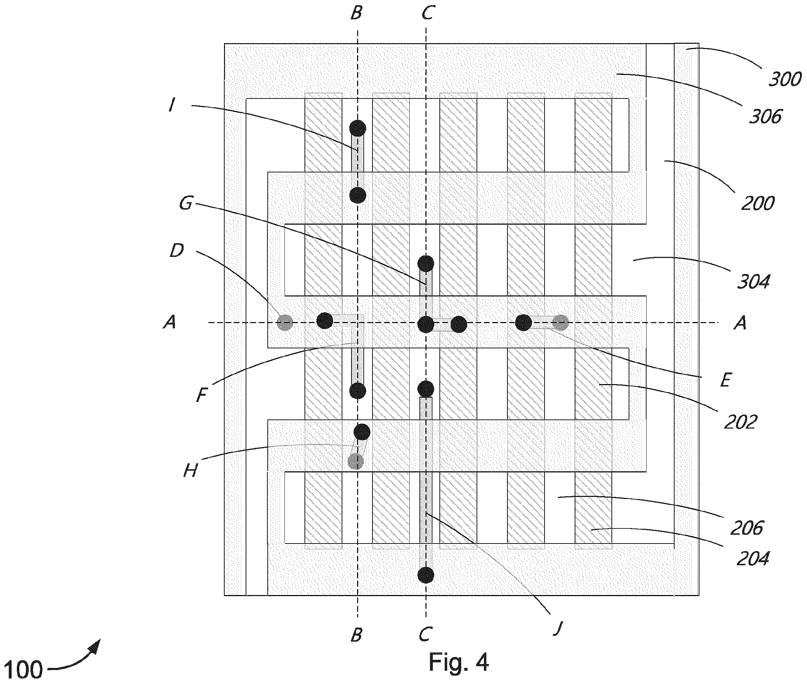

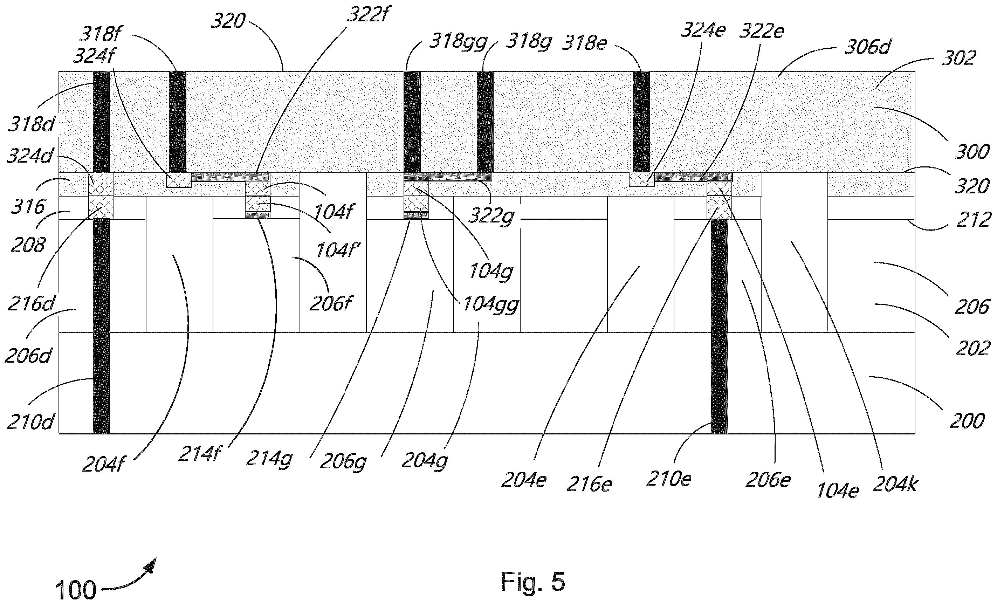

FIG. 1 is a schematic perspective view of an embodiment of a semiconductor device 100, in accordance with various embodiments. FIG. 2 is a top view of the semiconductor device 100 of FIG. 1. FIG. 3 is a top view of an embodiment of the semiconductor device 100 of FIG. 1. FIG. 4 is a top view of another embodiment of the semiconductor device 100 of FIG. 1 with a transparent second substrate 300. The second substrate 300 is transparent in FIG. 4 for illustrative purposes in order to show one or more vias, lines, or connectors, or the like located between the first substrate 200 and the second substrate 300. However, the second substrate 300 typically would not be transparent. FIGS. 5-7 are cross-sectional views of the semiconductor device 100 of FIG. 4 taken along various lines.

The semiconductor device 100 can include a packaging substrate 102 (e.g., a supporting material upon which or within which the elements of a semiconductor device are fabricated or attached). In various cases, the packaging substrate 102 can be formed from one or more layers. The one or more layers can include, without limitation, one or more dielectric layers, one or more device layers, one or more conducting layers, one or more insulating layers, one or more redistribution layers, and/or the like. In some cases, the packaging substrate 102 can be formed from silicon, glass, ceramic, or other substrate material. In some cases, the packaging substrate 102 could be coupled to a circuit board (e.g., a printed circuit board or the like) or be a circuit board.

In some embodiments, the semiconductor device 100 can further include a first substrate 200. The first substrate 200 can include one or more first intermediate or outer layers 202 comprising one or more first channels 204 (e.g., channels, cavities, voids, etc.) and one or more first ridges 206. In various cases, the one or more first intermediate or outer layers 202 could be one or more layers of the first substrate 200 that are indirectly coupled to the second substrate 300. In some cases, the first substrate 200 could be a coldplate or a heatsink comprising one or more channels, a component or a substrate comprising one or more vacuum cavities, or another component or substrate comprising one or more channels, or the like. In some cases, when the first substrate 200 comprises one or more vacuum cavities, the one or more vacuum cavities could include one or more sensors, one or more transducers, or the like. In some cases, for example, when the first substrate 200 is a coldplate or a heatsink, the one or more first channels 204 can contain or can be configured to contain a liquid. In a non-limiting example, the liquid could be a liquid configured to cool the semiconductor device 100, one or more active devices (e.g., transistors, diodes, or the like) located on or within semiconductor device 100, one or more device dies of the semiconductor device 100, or the like. In some cases, the liquid could be water or other liquid configured to cool the semiconductor device 100, the one or more active devices, the one or more device dies, or the like.

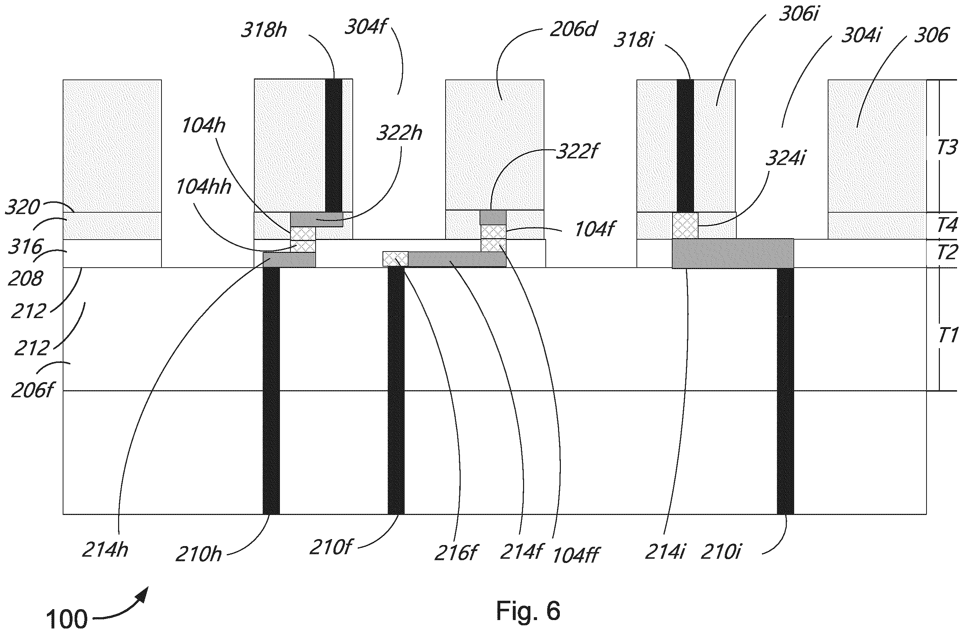

The first substrate 200 can further include one or more second surface layers 208 (e.g., one or more bonding layers or the like) as shown in FIGS. 5-7. The one or more second surface layers 208 could be one or more outer layers of the first substrate 200 that are directly coupled to the second substrate 300. The one or more second surface layers 208 will be described in more detail below. In some cases, a first ratio of a first thickness T1 of the first layer of the one or more first intermediate or outer layers 202 to a second thickness T2 of the second layer of the one or more second surface layers 208 is between about 250:1 and 10:1 as shown in FIG. 6. However, other ratios are possible and within the scope of this disclosure. In some cases, one or more insulating or dielectric layers can be included between the one or more second surface layers 208 and the one or more first layers 202.

In various embodiments, the semiconductor device 100 can further include a second substrate 300. The second substrate 300 can include one or more third intermediate or outer layers 302 comprising one or more second channels 304 (e.g., channels, cavities, voids, etc.) and one or more second ridges 306. In various cases, the one or more first intermediate or outer layers 302 could be one or more layers of the second substrate 300 that are indirectly coupled to the first substrate 200. In various cases, the second substrate 300 could be a coldplate or a heatsink comprising one or more channels, a component or a substrate comprising one or more vacuum cavities, or another component or substrate comprising one or more channels, or the like. In some cases, when the second substrate 300 comprises one or more vacuum cavities, the vacuum cavities could comprise one or more sensors, one or more transducers, or the like. In some cases, for example, when the second substrate 300 is a coldplate or a heatsink, the one or more second channels 304 can contain or can be configured to contain a liquid (e.g., similar to the liquid described above with respect to the first substrate 200).

In some cases, the liquid could be configured to enter the one or more first channels 204 of the first substrate 200 or the one or more second channels 304 of the second substrate 300 through one or more inlet ports 308 of the second substrate 300 and exit the first substrate 200 or second substrate 300 through one or more outlet ports 310 of the second substrate 300 as shown in FIGS. 1-3. In some instances, the one or more inlet ports 308 or the one or more outlet ports 310 can be configured to allow liquid to enter or exit through a side 312 of the second substrate 300. In other cases, the one or more inlet ports 308 or the one or more outlet ports 310 can be configured to allow liquid to enter or exit through a top (or bottom) 314 of the second substrate 300. In various cases, the first substrate 200 or the second substrate 300 can have more or less inlet ports 308 or outlet ports 310 than those shown.

In various cases, the one or more second channels 304 can be offset (e.g., at least partly spaced away, at least partly angled away, out of line, displaced, or the like) from the one or more first channels 204. In other words, the one or more second channels 304 may not fully overlap or be in line with the one or more first channels 204. In some cases, the one or more second channels 304 can be about perpendicular to the one or more first channels 204 as shown in FIGS. 1-3. In some cases, the one or more second ridges 306 can be offset (e.g., at least partly spaced away, at least partly angled away, or the like) from the one or more first ridges 206. In other words, the one or more second ridges 306 may not fully overlap or be in line with the one or more first ridges 206. In some cases, the one or more second ridges 306 can be about perpendicular to the one or more first ridges 206 as shown in FIGS. 1-3. In some cases, at least one first channel 204 might extend underneath or to an edge 309 of one or more connecting second ridges 307 connecting the one or more second ridges 306 as shown in FIG. 3. Alternatively, in other cases, the one or more first channels 204 might not extend underneath or to the edge 309 of one or more connecting second ridges 307 as shown in FIG. 2. Various other configurations of the one or more channels and one or more ridges are possible and within the scope of this disclosure.

The second substrate 300 (shown by the light gray shaded areas in FIGS. 2-7) can further include one or more fourth surface layers 316 (e.g., one or more bonding layers or the like) as shown in FIGS. 5-7. In some cases, the one or more fourth surface layers 316 can be one or more outer layers of the second substrate 300 that are directly coupled to the first substrate 200 or one or more second surface layers 208. The one or more fourth surface layers 316 will be described in more detail below. In some cases, a first ratio of a third thickness T3 of the third layer of the one or more third intermediate or outer layers 302 to a fourth thickness T4 of a fourth layer of the one or more fourth surface layers 316 is between about 250:1 and about 10:1 as shown in FIG. 6. However, other ratios are possible and within the scope of this disclosure. In some cases, one or more insulating or dielectric layers can be included between the one or more fourth surface layers 316 and the one or more third layers 302.

In some instances, the semiconductor device 100 could be configured to include a coldplate or heatsink comprising the first substrate 200 and the second substrate 300. The first substrate 200 could be a microchannel plate comprising one or more first channels 204 configured to receive a fluid. The second substrate 300 can be a manifold structure configured to distribute the fluid through the one or more second channels 304 and the one or more first channels 204. Each of the first substrate 200 or the second substrate 300 could be formed from silicon or other substrate material or combination of substrate materials or the like. The coldplate or heatsink could be configured to dissipate heat from the packaging substrate 102 or one or more device dies of the semiconductor device 100 or the like.

In various cases, the semiconductor device 100 might further include one or more device dies (not shown). The one or more device dies can include, without limitation, one or more circuits, one or more active devices (e.g., transistors, or the like), or one or more passive devices (e.g., wiring or the like) configured to perform a function. In various cases, the one or more device dies could include, without limitation, one or more microprocessors, one or more switches, one or more memory circuits, or other component or circuit configured to perform a function. In various cases, the one or more first channels 204 or second channels 304 might be located near the device die and be configured to dissipate or transfer heat from the device die. In some cases, packaging substrate 102, first substrate 200, or second substrate 300 could be directly coupled to a device die. In various cases, the packaging substrate 102 could comprise the device die or be the device die.

In some instances, the first substrate 200 can further include one or more first vias 210 and the second substrate 300 can include one or more second vias 318 (as shown in FIGS. 3-7). The one or more first vias 210 might extend through one or more first intermediate or outer layers 202 of the first substrate 200 to a first surface 212 of the one or more first ridges 206. The first surface 212 can be located between the one or more first intermediate or outer layers 202 and the one or more second surface layers 208. The one or more second vias 318 might extend through the one or more third intermediate or outer layers 302 of the second substrate 300 to a second surface 320 of the one or more second ridges 306. The second surface 320 can be located between the one or more third intermediate or outer layers 302 and the one or more fourth surface layers 316.

The one or more vias 210 or 318 can include, without limitation, one or more through silicon vias and/or one or more through substrate vias (TSVs). The one or more vias 210 or 318 can be configured to extend completely through the one or more first intermediate or outer layers 202 of the substrate 200 or the one or more third intermediate or outer layers 302 of the substrate 300 (e.g., a "through" via) or at least partially through the substrate 200 or 300 and can be formed from a conductive material. The conductive material of the one or more vias 210 or 318 can include a metal such as copper, tungsten, nickel, aluminum, gold, silver, tin, or a combination of metals/alloys, or may be formed of other electrically conductive material or combination of electrically conductive materials. The one or more vias 210 or 318 can be configured to form one or more electrical connections for power or one or more signals to travel or be transmitted through the semiconductor device 100, the packaging substrate 102, the first substrate 200, the second substrate 300, the device die, and/or the like.

In some cases, the semiconductor device 100 can further include one or more first lines 214 or one or more second lines 322. The one or more lines 214 or 322 could include, without limitation, a conductive line, a conductive strap, a conductive strip, a conductive trace, a conductive wire, a conductive band, or the like. In some examples, the one or more first lines 214 or the one or more second lines 322 can be formed of a metal such as copper, aluminum, gold, silver, tin, nickel, or a combination of metals/alloy, or may be formed of other electrically conductive material or combination of materials. In some cases, the one or more first lines 214 or one or more second lines 322 can be formed from one or more layers. In various cases, the one or more layers could include one or more layers of conductive material, dielectric material, or a combination of s conductive material and a dielectric material, or the like. Additionally, in some cases, two or more lines can be formed in two or more layers of the one or more second surface layers or fourth surface layers.

The one or more first lines 214 can be configured to connect to one or more first connectors (e.g., one or more first conductive surfaces or pads 216, one or more second conductive surfaces or pads 324, one or more second lines 322, one or more bonding pads 104, or the like). The one or more second lines can be configured to connect to one or more second connectors (e.g., the one or more first lines 214, the one or more first pads 216, the one or more second pads 324, or the one or more bonding pads 104, or the like).

The one or more first pads 216 can be configured to connect to the one or more first vias 210 while the one or more second pads 324 can be configured to connect to the one or more second vias 318. The one or more bonding pads 104 can be configured to couple the one or more first lines 214 to a corresponding one or more second lines 322, can be configured to couple the one or more first lines 214 to a corresponding pad 216 or 324 or via 210 or 318, can be configured to couple the one or more second lines 322 to a corresponding pad 216 or 324 or via 210 or 318, or can be configured to couple to another bonding pad. The one or more first pads 216, the one or more second pads 324, or the one or more bonding pads 104 could include one or more conductive elements, one or more conductive lines, one or more bonding pads or bonding surfaces, one or more via pads, or the like. In some instances, the one or more first pads 216 can surround (e.g., at least partly or fully surround) a surface of the one or more first vias 210 while the one or more second pads 324 can surround a surface of the one or more second vias 318.

Alternatively, in some cases, the one or more first lines 214 can be configured to connect directly to the one or more first vias 210 or the one or more second vias 318 while the one or more second lines 322 can be configured to connect directly to the one or more first vias 210 or the one or more second vias 318.

Turning to FIG. 3, the one or more first vias 210, the one or more second vias 318, the one or more first pads 216, or the one or more second pads 324 can be arranged in various ways on the one or more first ridges 206 or one or more second ridges 306, respectively. In various cases, the one or more first vias 210, the one or more second vias 318, the one or more first pads 216, or the one or more second pads 324 can be arranged along about a center or a central axis of the one or more ridges 206 and 306 (as shown in Example A by second via pads 324a of FIG. 3). In some instances, the one or more first vias 210, the one or more second vias 318, the one or more first pads 216, or the one or more second pads 324 can be arranged within one or more rows or columns on the one or more ridges 206 and 306 (as shown in Example B by one or more second pads 324b of FIG. 3). In some instance, two-dimensional orthogonal or non-orthogonal arrays of the one or more first vias 210, the one or more second vias 318, the one or more first pads 216, or the one or more second pads 324 can be formed the one or more ridges 206 and 306. In some cases, the one or more first vias 210, the one or more second vias 318, the one or more first pads 216, or the one or more second pads 324 can be arranged in one or more staggered columns or rows or offset from one another (as shown in Example C by one or more second pads 324c in FIG. 3). By arranging the one or more first vias 210, the one or more second vias 318, the one or more first pads 216, or the one or more second pads 324 in one or more rows or columns on the ridges 206 and 306, a higher number or density of vias 210 or 318 can be obtained.

Once the one or more first vias 210, the one or more second vias 318, the one or more first lines 214, the one or more second lines 322, the one or more first pads 216, or the one or more second pads 324 are formed, the one or more second surface layers 208 can be formed on the first layer 202 of the first substrate 200 or the one or more fourth surface layers 316 can be formed on the third layer 302 of the second substrate 300. The one or more second surface layers can be configured to surround (e.g., at least partially or fully) one or more of the one or more first lines 214, the one or more first pads 216, or the one or more bonding pads 104, or the like. The one or more fourth surface layers can be configured to surround (e.g., at least partially or fully) one or more of the one or more second lines 322, the one or more second pads 324, or the one or more bonding pads 104, or the like.

The one or more second surface layers 208 or the one or more fourth surface layers 316 can be one or more bonding layers formed between the first substrate 200 and the second substrate 300 and configured to couple the first substrate 200 to the second substrate 300. In various cases, the one or more second surface layers 208 and the one or more fourth surface layers 316 can be directly coupled together to form a seal (e.g., a full seal, a substantial seal, a partial seal, etc.) between the first substrate 200 and the second substrate 300. In various cases, the one or more second surface layers 208 and the one or more fourth surface layers 316 can prevent (e.g., fully, substantially, or partially) liquid in the one or more first channels 204 or the one or more second channels 304 from leaking from the coupling between first substrate 200 or the second substrate 300 or from contacting one or more of the one or more first vias 210, the one or more second vias 318, the one or more first lines 214, the one or more second lines 322, the one or more first pads 216, the one or more second pads 324, or the one or more bonding pads 104, or other conductive elements contained within the first substrate 200 or the second substrate 300.

The one or more second surface layers 208 or the one or more fourth surface layers 316 can include one or more zero-clearance bonding layers such as one or more hybrid bonding surfaces, one or more direct bonding surfaces, one or more surface activated bonding surfaces, or the like. The one or more hybrid bonding surfaces can include one or more surfaces that have more than one material (e.g., a combination of an insulator or dielectric material and a conductive material, or the like). The one or more direct bonding surfaces can include directly bonding two surfaces (e.g., two layers) together without intermediate layers between the two surfaces. The one or more surface activated bonding surfaces can comprise one or more surfaces that are chemically treated or treated with a plasma process to enhance bond energy between the one or more surfaces. By using the one or more zero-clearance bonding layers, one or more conductive elements or conductive materials contained within the one or more zero-clearance bonding layers can be sealed (e.g., fully, substantially, or partially) from liquid in the one or more first channels 204 or the one or more second channels 304. In each of the zero-clearance bonding situations described above, the zero-clearance bonding surfaces or layers can be bumpless (e.g., without solder bumps or the like) which allows the surfaces of the or more second surface layers 208 or the one or more fourth surface layers 316 to sit substantially or fully flush (e.g., without gaps or mostly without gaps between the or more second surface layers 208 or the one or more fourth surface layers 316) against each other.

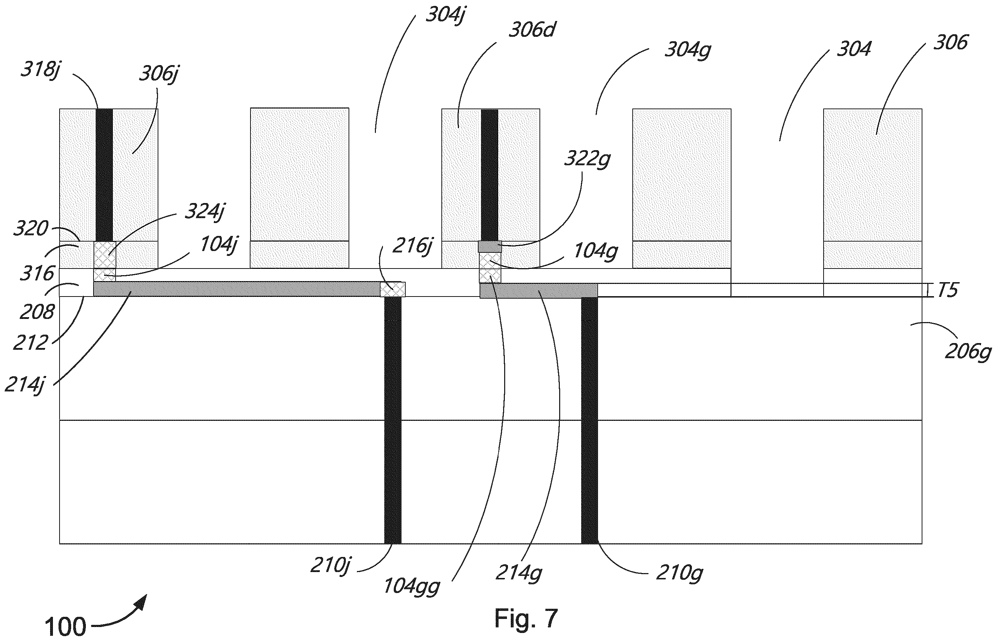

In various cases, the one or more second surface layers 208 or the one or more fourth surface layers 316 can comprise one or more layers that combine a dielectric material (e.g., silicon oxide, or the like) with an embedded (e.g., at least partially, substantially, or fully embedded within the one or more second surface layers 208 or the one or more fourth surface layers 316) metal (such as the one or more first lines 214 or second lines 322, the one or more first pads 216 or second pads 324, or the one or more bonding pads 104, or the like) to form one or more interconnections (e.g., interconnections between the first substrate 200 and the second substrate 300 or interconnections between other parts or components of the semiconductor device 100, or the like). A third ratio of a second thickness T2 (shown in FIG. 6) of the dielectric material (e.g., second layer 208 or fourth layer 316, or the like) to a fifth thickness T5 (shown in FIG. 7) of the embedded metal (e.g., first line 214 or second line 322) can be between about 1:1 to about 30:1. However, other ratios are possible and within the scope of this disclosure.

In some instances, the embedded metal of one of the one or more second surface layers 208 or the one or more fourth surface layers 316 can be located on (e.g., coupled or directly coupled to) the surface 212 or 320 of the one or more ridges 206 or 306. The embedded metal can be configured to connect to one or more corresponding connectors (such as the one or more first lines 214 or second lines 322, the one or more first pads 216 or second pads 324, or the one or more bonding pads 104, or the like) on the other of the one or more second surface layers 208 or the one or more fourth surface layers 316 or other component or connector of the semiconductor device 100.

In various cases, the one or more first lines 214 can be configured to extend along the surface 212 of a first ridge 206 of a channel 204 and connect to the one or more first vias 210, to the one or more first pads 216, or the like. In various cases, the one or more first lines 214 can be configured to extend along about a center of the first ridge 206. Alternatively, the one or more first lines 214 can be configured to be offset from a center of the first ridge 206. In some cases, two or more first lines 214 can be configured to extend next to each other along the first ridge 206. The one or more first lines 214 can further be configured to couple to one or more second vias 318, one or more second lines 322, or one or more second pads 324, located on or within the second substrate 300 or one or more bonding pads 104 located on or within the first or second substrate 200 or 300.

In some cases, the one or more second lines 322 can be configured to extend along the surface 320 of a second ridge 306 of a second channel 304 and connect to the one or more second vias 318, to the one or more second pads 324, or the like. In various cases, the one or more second lines 322 can be configured to extend along about a center of the second ridge 306. Alternatively, the one or more second lines 322 can be configured to be offset from a center of the second ridge 306. In some cases, two or more second lines 322 can be configured to extend next to each other along the second ridge 306. The one or more second lines 322 can further be configured to couple to one or more first vias 210, one or more first lines 214, or one or more first pads 216 located on or within the first substrate 200 or one or more bonding pads 104 located on or within the first or second substrate 200 or 300.

The one or more first vias or second vias 210 or 218, the one or more first pads or second pads 216 or 324, the one or more first lines 214 or second lines 322, and the one or more bonding pads 104 can be arranged in a variety of ways within or on the first and second substrate 200 and 300. The following paragraphs set forth some non-limiting examples of various arrangements of the one or more elements within the first substrate and the second substrate 300. However, these examples are only some of the possible arrangements and many others are possible and within the scope of this disclosure.

For example, as shown in Example D of FIGS. 4 and 5, a first via 210d can be connected (e.g., electrically connected or the like) to a second via 318d via a first pad 216d embedded within the second layer 208 and located on the ridge 206d and a second pad 324d embedded within the fourth layer 316 and located on the ridge 306d. In some cases, the first pad 216d and the second pad 324d could be one or more bonding pads 104 or a combination one or more of the first pad 216d, the second pad 324, and one or more bonding pads 104.

In some cases, as shown in Example E of FIGS. 4 and 5, a second via 318e located over a first channel 204e of the first substrate 200 can be connected to a first via 210e via a second pad 324e, a second line 322e, and a bonding pad 104e embedded within the fourth layer 316. The second line 322e can extend along the ridge 306d between the third layer 302 and the fourth layer 316 until it reaches a first ridge 206e of the first substrate 200. Once the second line 322e reaches the first ridge 206e, the second line 322e can be connected to the bonding pad 104e which can then be connected to a first pad 216e connected to the first via 210e. Alternatively, in some cases, the second line 322e can be directly connected the first pad 216e. The first pad 216e can be embedded within the second layer 208 of the first substrate 200.

In some embodiments, as shown in Example F of FIGS. 4, 5, and 6, a second via 318f located over a first channel 204f of the first substrate 200 can be connected to a first via 210f located over a second channel 304f by a second pad 324f, a second line 322f, and a bonding pad 104f embedded within the fourth surface layer 316. In some cases, the second line 322f can be directly connected to the second via 318f without the second pad 324f. The second line 322f can extend along the ridge 306d between the third layer 302 and the fourth layer 316 until it reaches a first ridge 206f of the first substrate 200. Once the second line 322f reaches the first ridge 206f, the second line 322f can be connected to the bonding pad 104f which can then be connected to another bonding pad 104ff. The bonding pad 104ff can then be connected to a first line 214f which can extend along the first ridge 206f and couple to first pad 216f connected to the first via 210f. In some cases, the second line 322f can be directly coupled to the first line 314f without any bonding pads. In some cases, the first line 214f can be directly connected to the first via 210f without the first pad 216f. The bonding pad 104ff, the first line 214f, and the first pad 216f can be embedded within the second layer 208 of the first substrate 200.

In some embodiments, as shown in Example G of FIGS. 4, 5, and 7, a second via 318g located over a first channel 204g of the first substrate 200 can be connected to a second via 318gg and a first via 210g located over a second channel 304g by a second line 322g and a bonding pad 104g embedded within the fourth layer 316. The second line 322g can extend along the ridge 306d between the third layer 302 and the fourth layer 316 until it reaches a first ridge 206g of the first substrate 200. Once the second line 322f reaches the first ridge 206g, the second line 322g can be connected to the bonding pad 104g which can then be connected to another bonding pad 104gg. The bonding pad 104gg can then be connected to a first line 214g which can extend along the first ridge 206g and couple to the first via 210g. In some cases, the second line 322g can be directly coupled to the first line 214g without any bonding pads. The bonding pad 104gg and the first line 214g can be embedded within the second layer 208 of the first substrate 200.

In some cases, as shown in Example H of FIGS. 4 and 6, a second via 316h can be connected to a first via 210h that is offset from the second via 318h via a second line 322h and a bonding pad 104h embedded within the fourth layer 316. The second line 322h can extend between the third layer 302 and the fourth layer 316 until the second line 322 reaches a bonding pad 104hh. Once the second line 322e reaches the bonding pad 104hh, the second line 322h can be connected to the bonding pad 104h which can then be connected to a bonding pad 104hh connected to a first line 214h. The first line can then extend between the first layer 202 and the second layer 208 until it reaches and connects to the first via 210h. The bonding pad 104hh and the first line 214h can be embedded within the second layer 208.

In some cases, as shown in Example I of FIGS. 4 and 6, a first via 210i located over a second channel 304i of the second substrate 300 can be connected to a second via 318i via a first line 214i embedded within the second layer 208 or coated with the second surface layer 208 to prevent a fluid from contacting the first line 214i. In some cases, a width of the second ridge 306i could also be increased to cover the first line 214i. The first line 214i can extend along the ridge 206g between the first layer 202 and the second layer 208 until it reaches a second ridge 306i of the second substrate 300. Once the first line 214i reaches the second ridge 306i, the first line 214i can be directly connected to a second pad 324i connected to the second via 318i. Alternatively, in some cases, the first line 214i can be indirectly connected the second pad 324i or the second via 318i via a bonding pad (not shown). The second pad 324i can be embedded within the fourth layer 316 of the second substrate 300.

In some cases, as shown in Example J of FIGS. 4 and 7, a first via 210j located over a second channel 304j of the second substrate 300 can be connected to a second via 318j located on a ridge 306j that is not adjacent to the second channel 304j. The connection can be formed via a first line 214j and a bonding pad 104j embedded within the second layer 208. The first line 214j can extend along the ridge 206g between the first layer 202 and the second layer 208 until it reaches a second ridge 306j of the second substrate 300. Once the first line 214j reaches the second ridge 306j, the first line 214j can be connected to the bonding pad 104j which can then be connected to a second pad 324j connected to the second via 318j. Alternatively, in some cases, the first line 214j can be directly connected the second pad 324j or the second via 318j. The second pad 324j can be embedded within the fourth layer 316 of the second substrate 300.

These are only some of the arrangements that are possible with the one or more first vias or second vias 210 or 218, the one or more first pads or second pads 216 or 324, the one or more first lines 214 or second lines 322, and the one or more bonding pads 104 and many other arrangements are possible and are within the scope of the embodiments. In various cases, the one or more lines 214 or 322 can be routed between, around, over, along, or across the ridges and connected to the one or more first vias or second vias 210 or 218, the one or more first pads or second pads 216 or 324, the one or more first lines 214 or second lines 322, and the one or more bonding pads 104, or the like in any arrangement as required by design, without limitation.

In some embodiments, as shown in FIGS. 5-7, the one or more second surface layers 208 or the one or more fourth surface layers 316 can optionally be deposited underneath and/or on top of the one or more first vias or second vias 210 or 218, the one or more first pads or second pads 216 or 324, the one or more first lines 214 or second lines 322, and the one or more bonding pads 104, or the like. The one or more layers 208 and 316 can be one or more dielectric layers or insulating layers. The one or more layers 208 and 316 can be formed from inorganic material such as silicon dioxide, silicon nitride, silicon carbon nitride, or organic material such as a photodefinable or non-photodefinable polymer, and/or another other material suitable for use as a dielectric layer or insulating layer. The one or more layers 208 and 316 can be selectively located at locations where the one or more first vias or second vias 210 or 218, the one or more first pads or second pads 216 or 324, the one or more first lines 214 or second lines 322, and the one or more bonding pads 104, or the like are formed. In a non-limiting example, the one or more layers 208 or 316 can be deposited where one or more lines 214 or 322 extend along the one or more ridges 206 or 306 and not be deposited in one or more locations (e.g., on the portion of ridge 306d located over channel 204k, or the like) where there are no lines 214 or 322 or other conductive elements.

By selectively locating the one or more layers 208 and 316 at locations where the one or more first vias or second vias 210 or 218, the one or more first pads or second pads 216 or 324, the one or more first lines 214 or second lines 322, and the one or more bonding pads 104, or the like are formed, heat transfer can be increased at locations between the first substrate 200, the second substrate 300, another component (e.g., a device die) or the like where the one or more layers 208 and 316 are not formed. However, the one or more layers 208 and 316 can fully cover any portions of metal that would otherwise come in contact with a fluid contained within the one or more channels 204 or 304. By covering the one or more first vias or second vias 210 or 218, the one or more first pads or second pads 216 or 324, the one or more first lines 214 or second lines 322, and the one or more bonding pads 104, or the like with the one or more layers 208 and 316, corrosion or other unwanted chemical reactions can be prevented.

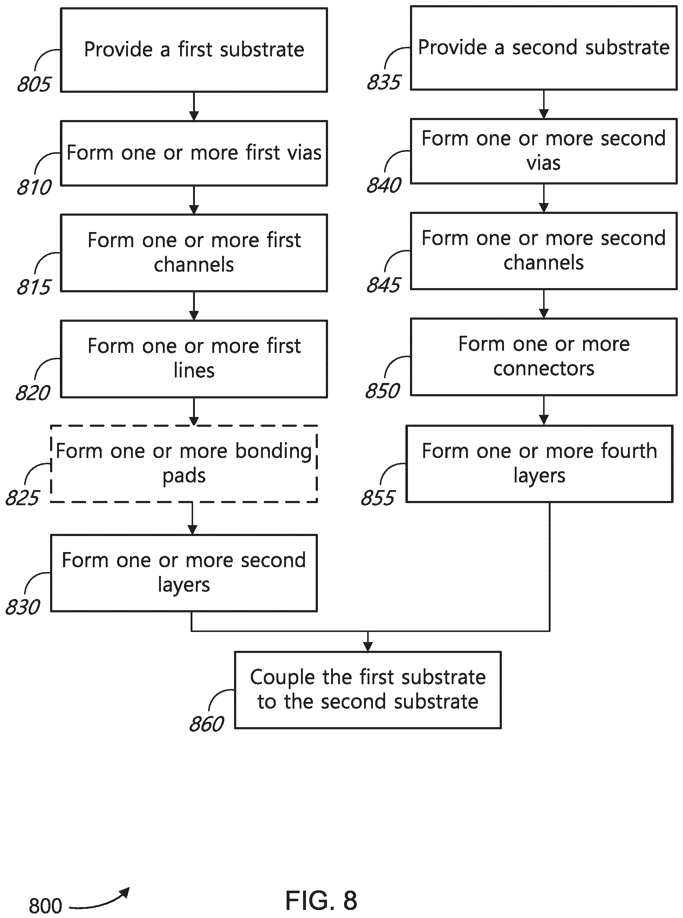

FIG. 8 is a flow diagram of a method of manufacturing a semiconductor device, in accordance with various embodiments. The method described in FIG. 8 is one way the components of FIGS. 1-7 can be manufactured. However, other methods may be used to manufacture the components of FIGS. 1-7.

Turning to FIG. 8, the method 800 may begin, at block 805, by providing or forming a first substrate (e.g., a substrate 200, or other component of a semiconductor device comprising one or more channels, or the like). The first substrate can include one or more first intermediate or outer layers (e.g., first layers 202 or the like). Next, one or more first vias (e.g., first vias 210, or the like) can be formed within the first substrate at block 810. In some cases, one or more first channels (e.g., first channels 204 or the like) can then be formed in the first substrate at block 815. One or more first ridges (e.g., first ridges 206 or the like) can be used to separate the one or more first channels from another of the one or more first channels. The method 800 can further include forming one or more first lines (e.g., first lines 214 or the like) on or connecting the one or more first lines to a top surface of one or more first ridges at block 820. The one or more first lines can be configured to extend along a surface of a corresponding first ridge of the one or more first ridges. In some cases, the one or more first lines can be connected to the one or more first vias.

In some cases, the method 800, at optional block 825, can include forming one or more bonding pads (e.g., bonding pads 104 or the like) connected to the one or more first lines. The one or more bonding pads can be used to connect the one or more first lines to one or more connectors located on another substrate or component of the semiconductor device. Method 800, at block 830, can further include forming one or more second surface layers (e.g., second layers 208 or the like) on the one or more first intermediate or outer layers of the first substrate. The one or more second surface layers can encapsulate (e.g., at least partially, substantially, or fully) the one or more first lines and the optional bonding pad.

The method can continue, at block 835, by providing or forming a second substrate (e.g., a second substrate 300, or other component of a semiconductor device comprising one or more channels, or the like). The second substrate can be formed at a same time or a same location as the first substrate or at a different time or different location than the first substrate. The second substrate can include one or more third intermediate or outer layers (e.g., third layers 302 or the like). Next, one or more second vias (e.g., second vias 318, or the like) can be formed within the second substrate at block 840. In some cases, one or more second channels (e.g., second channels 304 or the like) can then be formed in the second substrate at block 845. One or more second ridges (e.g., second ridges 306 or the like) can be used to separate the one or more second channels from another of the one or more second channels. The method 800 can further include forming one or more connectors (e.g., one or more second lines 322, one or more second pads 324, one or more bonding pads 104, or other connector, or the like) on or connecting the connector to a top surface of one or more second ridges at block 850. The one or more connectors can be connected to the one or more second vias.

In some cases, the method 800, at block 855, can include forming one or more one or more fourth surface layers (e.g., fourth layers 316 or the like) on the one or more third intermediate or outer layers of the second substrate. The one or more fourth surface layers can encapsulate (e.g., at least partially, substantially, or fully) the one or more connectors.

The method can then continue at block 860 by coupling the one or more second surface layers of the first substrate to the one or more fourth surface layers of the second substrate and coupling a first via of the first substrate to a second via of the second substrate via one or more of one or more lines, via pads, or bonding pads. The first substrate can be coupled to the second substrate using one or more zero-clearance bonding techniques such hybrid bonding, direct bonding, or surface activated bonding, or the like. The interface between the first substrate and the second substrate can be bumpless and substantially flat to ensure liquid does not leak from the one or more first channels or the one or more second channels.

While some features and aspects have been described with respect to the embodiments, one skilled in the art will recognize that numerous modifications are possible. Moreover, while the procedures of the methods and processes described herein are described in a particular order for ease of description, unless the context dictates otherwise, various procedures may be reordered, added, and/or omitted in accordance with various embodiments. Moreover, the procedures described with respect to one method or process may be incorporated within other described methods or processes; likewise, system components described according to a particular structural architecture and/or with respect to one system may be organized in alternative structural architectures and/or incorporated within other described systems. Hence, while various embodiments are described with or without some features for ease of description and to illustrate aspects of those embodiments, the various components and/or features described herein with respect to a particular embodiment can be substituted, added and/or subtracted from among other described embodiments, unless the context dictates otherwise. Consequently, although several embodiments are described above, it will be appreciated that the invention is intended to cover all modifications and equivalents within the scope of the following claims.

## Claims

1. A semiconductor device (100) comprising: A first substrate (200) comprising:
a first layer (202) comprising a first channel (204);
a first via (210) extending through the first layer (202) to a first surface (212) of a first ridge (206) of the first channel (204);
a second layer (208) coupled to the first layer (202), wherein the second layer (208) is a first outer layer of the first substrate (200); and
a first line (214) coupled to the first via (210) and extending along the first ridge (206) of the first channel (204) and embedded in the second layer (208).

2. The semiconductor device (100) of claim 1, wherein the first line (214) is located between the first layer (202) and the second layer (208).

3. The semiconductor device (100) of claim 1 or 2, wherein the second layer (208) is a dielectric layer.

4. The semiconductor device (100) of any of claims 1 to 3, wherein the first line (214) is connected to a bonding pad (104).

5. The semiconductor device (100) of claim 4, wherein the bonding pad (104) is connected to at least one of a second via (218), a pad, or an other bonding pad located on a second substrate (300).

6. The semiconductor device (100) of any of claims 1 to 5, further comprising:
a second substrate (300) comprising:
a third layer (302) comprising a second channel (304);
a second via (218) extending through the third layer (302) to a second surface of a second ridge (306) of the second channel (304);
a fourth layer (316) coupled to the third layer (302), wherein the fourth layer (316) is a second outer layer of the second substrate (300); and
a connector connected to the second via (218) and the first line (214) and embedded in the fourth layer (316).

7. The semiconductor device (100) of claim 6, wherein the connector is a second line (322) extending across the second ridge (306) of the second channel (304).

8. The semiconductor device (100) of claim 7, wherein the first line (214) is connected to the second line (322) by a bonding pad (104).

9. The semiconductor device (100) of claim 6 or 7, wherein the connector is a pad.

10. The semiconductor device (100) of any of claims 6 to 9, comprising at least one of the following features:
wherein the second ridge (306) of the second channel (304) is offset from the first ridge (206) of the first channel (204);
wherein the second ridge (306) of the second channel (304) is about perpendicular to the first ridge (206) of the first channel (204);
wherein the first via (210) is located over the second channel (304);
wherein the second substrate (300) comprises one or more inlet or outlet ports (308, 310) configured to receive a fluid, wherein the fluid is received in the first channel (204) and the second channel (304).

11. A semiconductor device (100) comprising:
a first substrate (200) comprising:
a first layer (202) comprising a first channel (204);
a first via (210) extending to a first surface (212) of the first layer (202), wherein the first surface (212) is a surface of a first ridge (206) of the first channel (204);
a second layer (208) coupled to the first layer (202), wherein the second layer (208) is a first outer layer of the first substrate (200); and
a first line (214) connected to the first via (210) and extending across the first ridge (206) of the first channel (204); and
a second substrate (300) comprising:
a third layer (302) comprising a second channel (304);
a second via (218) extending to a second surface of the third layer (302), wherein the second surface is a surface of a second ridge (306) of the second channel (304);
a fourth layer (316) coupled to the third layer (302), wherein the fourth layer (316) is a second outer layer of the second substrate (300); and
a connector coupled to the second via (218) and the first line (214).

12. The semiconductor device (100) of claim 11, comprising at least one of the following features:
wherein the connector comprises a second line (322) extending across the second ridge (306) of the second channel (304);
wherein a ratio of a thickness of the second layer (208) to a thickness of the first line (214) is between about 1:1 to about 30:1.

13. A method of manufacturing a semiconductor device (100), the method comprising:
forming a first substrate (200) comprising:
forming a first layer (202);
forming a first channel (204) in the first layer (202);
forming a first via (210) in the first layer (202) extending to a first ridge (206) of the first channel (204);
forming a first line (214) extending along the first ridge (206) of the first channel (204) and connected to the first via (210); and
forming a second layer (208) on the first ridge (206) of the first channel (204) and surrounding the first line (214).

14. The method of claim 13, further comprising:
forming a second substrate (300) comprising:
forming a third layer (302);
forming a second channel (304) in the third layer (302);
forming a second via (218) in the third layer (302) extending to a second ridge (306) of the second channel (304);
forming a connector coupled to the third layer (302) and connected to the second via (218) and the first line (214); and
forming a fourth layer (316) on the second ridge (306) of the second channel (304) and surrounding the connector.

15. The method of claim 14, comprising at least one of the following features:
wherein the connector comprises a second line (322) extending along the second ridge (306) and connected to the first line (214);
wherein the second layer (208) is formed in one or more first selected locations based on one or more first locations where the first line (214) is formed, wherein the fourth layer (316) is formed in one or more second selected locations based on one or more second locations where the connector is formed.
